# EUROPÄISCHE PATENTANMELDUNG

(11) **EP 2 385 629 A2**
(43) Veröffentlichungstag der Anmeldung: **09.11.2011**
(21) Anmeldenummer: 11162036.5
(22) Anmeldetag: 12.04.2011
(51) Int. Cl.: H03K 17/689

(54) **Ansteuerschaltung mit Übertragungsschaltung zur kapazitiven Übertragung eines Signals und zugeordnetes Verfahren**

(30) Priorität: 03.05.2010 DE 102010018997
(71) Anmelder: SEMIKRON Elektronik GmbH & Co. KG, 90431 Nürnberg (DE)
(72) Erfinder: Vogler, Bastian, 90763, Fürth (DE); Roßberg, Matthias, 98693, Ilmenau (DE); Dr. Herzer, Reinhard, 98693, Ilmenau (DE)

(57) **Zusammenfassung**

Die Erfindung betrifft eine Ansteuerschaltung mit Übertragungsschaltung zur Übertragung eines Signals von einer Primärseite mit erstem Grundpotential zu mindestens einer Sekundärseite mit jeweiligem zweitem Grundpotential mit einem Übertrager mit kapazitiver Kopplung zwischen der Primär- und der Sekundärseite. Hierbei weist der Übertrager zwei Zweige, einen ON- Übertragungszweig und einen OFF- Übertragungszweig auf, die ihrerseits je einen ersten und einen zweiten Teilzweig aufweisen, wobei die kapazitive Kopplung zwischen Primär- und Sekundärseite bei jedem Teilzweig durch Hochvolt-Kondensatoren ausgeführt wird. Gemäß dem erfindungsgemäßen Verfahren erzeugt in jedem Übertragungszweig das dortige Signal einen Stromfluss durch einen ersten HV- Kondensator eines ersten Teilzweiges und einen inversen Stromfluss durch einen zweiten HV- Kondensator eines zweiten Teilzweiges. Dieser jeweilige Stromfluss wird auf der Sekundärseite detektiert und einer beiden Teilzweigen gemeinsamen Auswerteschaltung (84) zugeführt, die das primärseitige Eingangssignal sekundärseitig rekonstruiert.

## Beschreibung

### Beschreibung

Die Erfindung beschreibt eine monolithisch integrierbare Ansteuerschaltung mit Übertragungsschaltungen und ein zugehöriges Verfahren zum Betrieb dieser Ansteuerschaltung zur Übertragung eines Eingangssignals vorzugsweise von einer Ansteuerlogik zu einem Treiber. Derartige Ansteuerschaltungen werden in leistungselektronischen Systemen benötigt, um Leistungshalbleiterschalter anzusteuern, die als Einzelschalter oder in einer Brückenschaltung angeordnet sind. Derartige Brückenschaltungen sind als Ein-, Zwei-, oder Dreiphasen-Brückenschaltungen, ausgebildet als Leistungshalbleitermodule, bekannt, wobei die einphasige sog. Halbbrücke den Grundbaustein einer Vielzahl von leistungselektronischen Schaltungen darstellt. In einer Halbbrückenschaltung sind zwei Leistungsschalter, ein erster sog. TOP-Schalter und ein zweiter sog. BOT- Schalter in einer Reihenschaltung angeordnet.

Eine derartige Halbbrücke weist in der Regel eine Verbindung zu einem Gleichstromzwischenkreis auf. Der Ausgang, typischerweise der Wechselspannungsanschluss der Halbbrücke ist meist mit einer Last verbunden. Die Ansteuerschaltung besteht in der Regel aus mehreren Teilschaltungen bzw. Funktionsblöcken. Das Steuersignal einer übergeordneten Steuerlogik, beispielhaft einem Mikrokontroller, wird in einer ersten Teilschaltung, der Ansteuerlogik, aufbereitet und über weitere Komponenten den Treiberschaltungen und schließlich dem Steuereingang des jeweiligen Leistungsschalters zugeführt.

Bei höheren Zwischenkreisspannungen, in der Regel größer 40V, wird meist die Ansteuerlogik potentialmäßig von den Treiberschaltungen getrennt, da sich die zugehörigen Leistungsschalter auf unterschiedlichem Potential befinden und somit eine spannungsmäßige Isolation unumgänglich ist. Diese Trennung gilt zumindest für den TOP-Schalter, wird aber bei höheren Leistungen auch für den BOT- Schalter auf Grund eines möglichen Verrisses des Massepotentials beim Schalten ausgeführt. Eine derartige Trennung kann zum einen mittels galvanischer Trennung, beispielhaft durch Impulsübertrager, Optokoppler bzw. Lichtwellenleiter oder zum anderen mittels integrierter Schaltungstechnik beispielhaft in einem HVIC (High Voltage Integrated Circuit, Hochspannungsschaltkreis) realisiert werden. Letztere Variante wird, aufgrund verschiedener Vorteile, wie geringe Abmessungen, niedriger Preis und lange Lebensdauer, mit zunehmender Häufigkeit eingesetzt. Hierzu bieten HVICs die Möglichkeit, ein Hochspannungsbauelement, mit einer Durchbruchspannung größer oder gleich der Zwischenkreisspannung zu integrieren, welche in Schaltkreisen zur Signalpegelumsetzung, in sog. Levelshiftern, eingesetzt werden kann. Üblicherweise wird für diese ein lateraler Hochspannungs- MOSFET verwendet.

Eine derartige Übertragungsschaltung ist Teil der Ansteuerschaltung und vorzugsweise ausgeführt als eine integrierte Schaltungsanordnung. Sie dient der Übertragung eines Signals von einem Schaltungsteil der Primärseite mit einem definierten Bezugspotential zu einem Schaltungsteil der Sekundärseite mit einem zeitweise höheren oder auch niedrigeren Bezugspotential. Es sind hier bidirektionale aber auch unidirektionale Übertragungsschaltungen bekannt.

Es sind zwei grundsätzliche Isolationstechnologien zur Ausbildung von HVICs bekannt. Einerseits die SOI-(Silicon on Insulator) Technologien und andererseits pnisolierte Technologien (Junction Isolation). Die SOI- Technologie bietet eine dielektrische Isolation von Bauelementen und Bauelementgruppen, steht aber derzeit nur bis 800V Spannungsfestigkeit zur Verfügung. Die SOI- Substratwafer sind deutlich teurer als Standardsubstrate, allerdings werden die Kosten durch eine Reihe technischer Vorteile sowie erhebliche Prozessvereinfachungen kompensiert, die sich aus der dielektrischen Isolation ergeben. Bei pn- isolierten Technologien wird die Sperrspannung von einen sperrgepolten pn- Übergang aufgenommen. Diese Technik steht derzeit bis 1200V zur Verfügung. Die Herstellung ist allerdings sehr aufwendig und somit kostenintensiv. Weiterhin gibt es technische Probleme, beispielhaft mit Leckströmen und Latch-up Effekten u.a. bei höheren Temperaturen, wie beispielhaft bei einer Betriebstemperatur über 125°C, sowie bei Verriss des Massepotentials bei schnellen dynamischen Vorgängen.

Bei integrierten Ansteuerschaltungen ist nach dem Stand der Technik die Übertragung der Ansteuersignale von der Ansteuerlogik zur, dem TOP- Schalter zugeordneten, TOP-Sekundärseite über Levelshifterschaltungen grundsätzlich bekannt. Die potentialgetrennte Ansteuerung ist notwendig, da die TOP-Sekundärseite, im Unterschied zur, dem BOT- Schalter zugeordneten, BOT-Sekundärseite, phasenweise auf einem erhöhten Bezugspotential liegt. Nach dem Stand der Technik von HVICs erfolgt die Signalübertragung von der Ansteuerseite zur TOP-Sekundärseite mittels gepulster (dynamischer), differentieller Übertragung, wobei aus dem zu übertragenden Signal ansteuerseitig Ein- und Ausschaltpulse erzeugt werden, die über einen Levelshifter auf die TOP-Sekundärseite übertragen werden. Diese Art der Übertragung zeichnet sich durch eine große Übertragungssicherheit und geringen Leistungsbedarf aus.

Der wesentlichste Nachteil des Verfahrens besteht in der notwendigen Erzeugung der Ein- und Ausschaltpulse. Dies hat einen erhöhten Schaltungsaufwand und Platzbedarf und somit höhere Kosten zur Folge. Grundsätzlich sind verschiedene integrierte Levelshiftertopologien bekannt. Die einfachste Topologie, besteht aus einem HV- (high voltage, Hochspannungs-) Transistor mit entsprechender Sperrfähigkeit und einem Widerstand in Reihenschaltung. Wird ein Signal auf das Gate des HV-Transistors gegeben, schaltet dieser ein. Der dadurch erzeugte Querstrom durch den Levelshifter verursacht einen Spannungsabfall über dem Widerstand, der als Signal von einer Auswerteschaltung erfasst werden kann. Derartige Levelshifter mit HV-Transistoren enthalten prinzipbedingt einen zur Signalübertragung notwendigen Querstrompfad zwischen Ansteuerlogik und Treiber, so dass keine galvanische Trennung erreicht wird.

In der DE 101 52 930 A1 wird eine verbesserte Levelshiftertopologie offenbart, bei der das Ansteuersignal schrittweise, mittels einer Mehrzahl gleichartiger, kaskadiert geschalteter Levelshifter, über Zwischenpotentiale übertragen wird. Damit sind Transistoren einsetzbar, die nur den Bruchteil der geforderten Sperrfähigkeit des gesamten Levelshifters besitzen. Somit kann die Sperrfähigkeit des Levelshifters wesentlich erhöht werden.

Die DE 10 2006 037 336 offenbart einen Levelshifter ausgeführt als eine Reihenschaltung von HV-Transistoren vom n-Kanal-Typ. Diese Topologie weist die Vorteile auf, dass gegenüber der DE 101 52 930 A1 zum einen der Leistungsverbrauch und zum anderen der Schaltungsaufwand verringert sind. Dies hat einen geringeren Platzbedarf und somit auch geringere Kosten zur Folge.

Allen genannten Topologien für HVICs ist gemein, dass bei komplementärem Aufbau des Levelshifters auch eine Signalübertragung von einem Schaltungsteil mit einem hohen Bezugspotential zu einem Schaltungsteil mit einem niedrigen Bezugspotential grundsätzlich möglich ist. Diese Eigenschaft kann für eine Signalrückübertragung von der TOP-Sekundärseite zur Ansteuerlogik genutzt werden. Voraussetzung hierfür ist allerdings ein HV- Tansistor vom p-Kanal-Typ.

Durch interne Induktivitäten eines Systems aus Leistungshalbleitermodul und Ansteuerschaltung, beispielhaft durch Leitungsinduktivitäten, kann es während des Schaltens der Leistungsschalter zu einem starken Verriss des Bezugspotentials der BOT- Sekundärseite in positiver oder negativer Richtung kommen. Ebenso kann es zu einem starken Verriss des Bezugspotentials der TOP-Sekundärseite unter das ansteuerseitige Bezugspotential kommen. Dies tritt in besonders starkem Maße in Systemen mittlerer und hoher Leistung auf, bei denen große Ströme, beispielhaft größer 50A, geschaltet werden. Die Potentialdifferenz kann dabei Werte annehmen, die über die Sperrspannung der in der Ansteuerschaltung verwendeten Transistoren, beispielhaft größer 20V, hinausgehen.

Die bekannten pn- Isolationstechnologien weisen den Nachteil auf, dass es bei einem entsprechenden Verriss des Bezugspotentials in negative Richtung zum Zünden parasitärer Thyristorstrukturen, dem sog. Latch-up, kommen kann. Dies führt zum Funktionsverlust und eventuell zur Zerstörung der betroffenen Transistoren.

Diese Einschränkung ist, bedingt durch die dielektrische Isolation der Bauelemente, bei SOI- Technologien nicht gegeben, so dass ein Levelshifter schaltungstechnisch umsetzbar ist, der auch bei kurzzeitig oder dauerhaft negativem sekundärseitigem Bezugspotential eine sichere Signalübertragung gewährleistet. Die DE 10 2006 050 913 A1 offenbart einen derartigen Levelshifter für die BOT-Sekundärseite ausgeführt in SOI- Technologie als UP- und DOWN- Levelshifterzweig, während die DE 10 2007 006 319 A1 einen derartigen Levelshifter für die TOP-Sekundärseite ebenso in SOI- Technologie ausgeführt als UP- und DOWN-Levelshifterzweig offenbart.

Der Erfindung liegt die Aufgabe zugrunde eine zumindest teilweise monolithisch integrierbare Ansteuerschaltung und ein zugehöriges Verfahren vorzustellen, wobei positive und negative Potentialunterschiede gleichartig und in gleicher Höhe überwunden werden können und primärseitig hierzu keine Pulserzeugungsschaltung notwendig ist.

Die Aufgabe wird erfindungsgemäß gelöst, durch eine Ansteuerschaltung mit den Merkmalen des Anspruchs 1 und durch ein Verfahren gemäß Anspruch 9. Bevorzugte Ausführungsformen sind in den jeweiligen abhängigen Ansprüchen genannt.

Der erfinderische Gedanke geht aus von einer Ansteuerschaltung mit einer Übertragungsschaltung, im Folgenden als Übertrager bezeichnet, zur vorzugsweise unidirektionalen Übertragung eines Signals von einem ersten Schaltungsteil mit erstem Bezugspotential, der Primärseite, zu einem zweiten Schaltungsteil mit zweitem Potential, einer Sekundärseite, beispielhaft der TOP-Sekundärseite. Ein derartiger Übertrager wird im Folgenden als UP-Übertrager bezeichnet, während ein DOWN-Übertrager ein Signal von einer Sekundärseite zur Primärseite überträgt. Der Übertrager selbst ist ausgebildet als eine Anordnung zweier identischer, unabhängig arbeitender Übertragungszweige sowie einer beiden Übertragungszweigen gemeinsamen nachgeschalteten Signalauswerteschaltung. Hierbei liegt das zu übertragende Signal direkt an einem ersten Übertragungszweig dem ON-Übertragungszweig, beispielhaft zum Einschalten eines Leistungsschalters, und in invertierter Form an dem zweiten Übertragungszweig, dem OFF- Übertragungszweig beispielhaft zum Ausschalten des Leistungsschalters an.

Der ON- Übertragungszweig erzeugt bei einer positiven Eingangssignalflanke des zu übertragenden Signals ein Einschaltsignal bestimmter Länge an seinem sekundärseitigen Ausgang. Der OFF- Übertragungszweig erzeugt bei einer negativen Eingangssignalflanke des zu übertragenden Signals ein Ausschaltsignal bestimmter Länge am seinem sekundärseitigen Ausgang. Die sekundärseitige Signalauswerteschaltung erfasst die Signale an diesen Ausgängen und rekonstruiert das zu übertragende Signal.

Erfindungswesentlich ist bei dem jeweiligen Übertragungszweig, dass die Übertragung von der Primär- zur Sekundärseite mittels zweier Kondensatoren in jeweils einem zugeordneten Teilzweig erfolgt, die die notwendige Spannungsfestigkeit für den Potentialunterschied aufweisen. Bei dem erfindungsgemäßen Verfahren zur Übertragung wird durch einen primärseitigen Schaltungsteil in jedem der Teilzweige ein Kondensator geladen während ein korrespondierender Kondensator entladen wird. Dieser Lade- bzw. Entladevorgang wird sekundärseitig detektiert.

Bei einem UP-Übertrager der erfindungsgemäßen Ansteuerschaltung wird aus einem Signal am Eingang der jeweiligen Übertragungszweige taktflankengesteuert ein sekundärseitiges Ausgangssignal erzeugt, ohne dass hierfür eine gesonderte Pulserzeugungsschaltung, wie bei Übertragern auf Basis von HV-Transistoren, auf der Primärseite benötigt wird.

Die erfinderische Lösung wird an Hand der Fig. 1 bis 7 weiter erläutert.

Fig. 1 zeigt ein Blockschaltbild mit einer monolithisch integrierten Ansteuerschaltung nach dem Stand der Technik.

Fig. 2 zeigt ein Blockschaltbild mit relevanten Teilen einer ersten erfindungsgemäßen monolithisch integrierten Ansteuerschaltung mit einem UP-Übertrager.

Fig. 3 zeigt eine Grundschaltung eines UP- Übertragers.

Fig. 4 zeigt Simulationsergebnisse des erfindungsgemäßen Verfahrens.

Fig. 5 zeigt ein Blockschaltbild mit relevanten Teilen einer zweiten erfindungsgemäßen monolithisch integrierten Ansteuerschaltung mit einem UP- und einem DOWN-Übertrager.

Fig. 6 zeigt eine Grundschaltung eines DOWN- Übertragers.

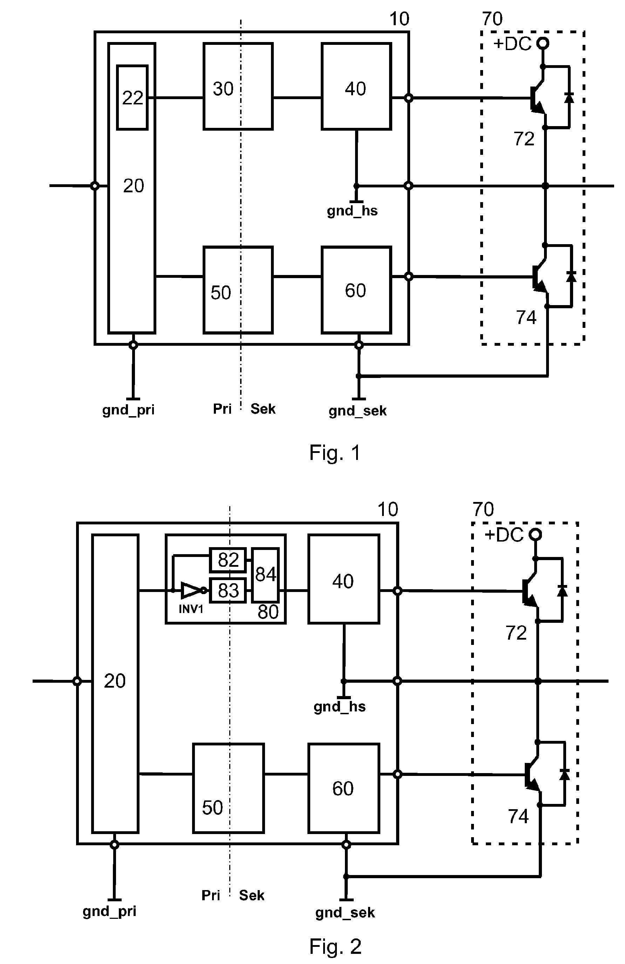

Fig. 1 zeigt zur Erläuterung der Erfindung ein Blockschaltbild mit einer monolithisch integrierten Ansteuerschaltung (10) nach dem Stand der Technik, sowie eine hierdurch ansteuerbare Halbbrückenschaltung (70). Diese Halbbrückenschaltung (70) weist einen TOP- (72) und einen BOT- Leistungsschalter (74) auf, die hier jeweils als ein IGBT mit antiparallel geschalteter Diode ausgebildet sind. Der BOT-Leistungsschalter (74) liegt auf dem Bezugspotential (gnd_sek) der Sekundärseite, welches bei Applikationen mit kleinen Leitungsinduktivitäten nahezu gleich dem Bezugspotential (gnd_pri) der Primärseite der Ansteuerschaltung (10) ist.

Die Ansteuerschaltung (10) selbst weist eine Ansteuerlogik (20) mit einer notwendigen Pulserzeugungsschaltung (22), einen ersten UP-Übertrager (30) mit nachgeschalteter TOP- Sekundärseite (40) sowie einen zweiten UP-Übertrager (50) mit nachgeschalteter BOT- Sekundärseite (60) auf, wobei die jeweiligen UP-Übertrager als Levelshifter gemäß dem Stand der Technik ausgebildet sind.

Fig. 2 zeigt ein Blockschaltbild mit relevanten Teilen einer erfindungsgemäßen monolithisch integrierten Ansteuerschaltung mit einem UP-Übertrager (80), der einen ON- Übertragungszweig (82), einen grundsätzlich identischen OFF-Übertragungszweig (83), und eine diesen Übertragungszweigen nachgeschalteten gemeinsamen Signalauswerteschaltung (84) aufweist. Das zu übertragende Signal wird an den ON- Übertragungszweig (82) direkt und an den OFF- Übertragungszweig (83) mittels eines vorgeschalteten ersten Inverter (INV1) angelegt. Der UP-Übertrager überträgt somit innerhalb der Ansteuerschaltung das Signal von der Primärseite (Pri) mit erstem Potential auf die Sekundärseite (Sek) mit zweitem Potential.

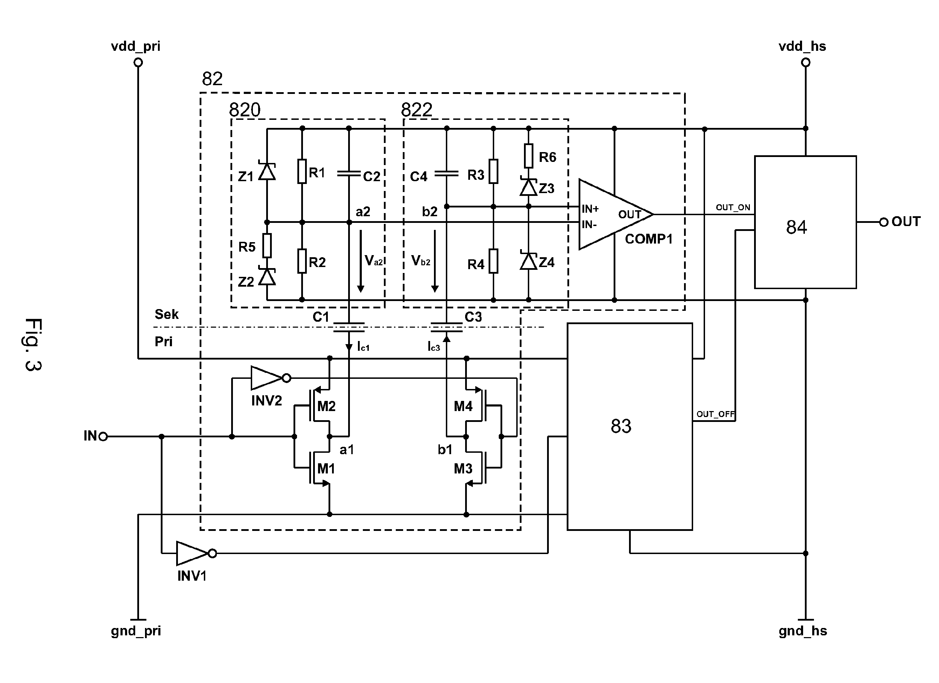

Fig. 3 zeigt eine Grundschaltung eines UP- Übertragers (80), bestehend aus einem ersten Inverter (INV1), einem ON- Übertragungszweig (82) und einem identischen OFF- Übertragungszweig (83) sowie einer Signalauswerteschaltung (84). Da beide Übertragungszweige identisch aufgebaut sind, ist ausschließlich der ON-Übertragungszweig im Detail dargestellt, wobei die folgenden allgemeinen Aussagen für beide Übertragungszweige gelten.

Der jeweilige Übertragungszweig besteht aus einem primärseitigen Schaltungsteil, einem sekundärseitigen Schaltungsteil und zwei HV-Kondensatoren (C1, C3), die die beiden Schaltungsteile verbinden. Der primärseitige Schaltungsteil weist zwei Brückenschaltungen (M1, M2 und M3, M4) auf, mit jeweils einem Transistor (M1, M3) vom n-Kanal-Typ und jeweils einem (M2, M4) vom p-Kanal-Typ. Die Source-Anschlüsse der n-Kanal Transistoren (M1, M3) sind an das primärseitige Bezugspotential (gnd_pri) und die Source-Anschlüsse der p-Kanal Transistoren (M2, M4) sind an die primärseitige Versorgungsspannung (vdd_pri) angeschlossen. Die Gate-Anschlüsse der Transistoren der ersten Brückenschaltung (M1, M2) sind direkt mit dem Eingang (IN) des UP- Übertragers (80) verbunden. Die Gate-Anschlüsse der Transistoren der zweiten Brückenschaltung (M3, M4) sind mit dem Ausgang eines zweiten Inverters (INV2) verbunden, dessen Eingang mit dem Eingang (IN) des UP-Übertragers (80) verbunden ist. Der erste HV-Kondensator (C1) ist einerseits mit dem Ausgang (a1) der ersten Brückenschaltung (M1, M2) und andererseits einem ersten sekundärseitigen Knotenpunkt (a2) verbunden. Die erste Brückenschaltung (M1, M2), der erste HV-Kondensator (C1) und der erste sekundärseitige Knotenpunkt (a2) bilden mit dessen Beschaltung den ersten Teilzweig aus. Der zweite Teilzweig ist grundsätzlich identisch aufgebaut und unterscheidet sich vom ersten nur in der Beschaltung des zweiten sekundärseitigen Knotenpunktes (b2).

Die Beschaltung der sekundärseitigen Knotenpunkte (a2, b2) ist folgendermaßen ausgebildet und mit einem ersten Komparator (COMP1) verbunden. Der erste Anschluss weiterer Kondensatoren (C2, C4) ist mit einem zugeordneten Knotenpunkt (a2, b2) verbunden, während der zweite Anschluss mit der Versorgungsspannung der Sekundärseite (vdd_hs) verbunden ist. Der sekundärseitige Knotenpunkt (a2) ist an den invertierenden Eingang (IN-) des ersten Komparators (COMP1) angeschlossen. Der sekundärseitige Knotenpunkt (b2) ist an den nicht invertierenden Eingang (IN+) des ersten Komparators (COMP1) angeschlossen. Die Widerstände (R1, R2 bzw. R3, R4) bilden jeweils einen Spannungsteiler zwischen der Versorgungsspannung der Sekundärseite (vdd_hs) und dem Bezugspotential der Sekundärseite (gnd_hs), deren Mittelpunkt mit dem zugeordneten Knotenpunkt (a2, b2) verbunden ist. Parallel zu den Spannungsteilern ist eine Reihenschaltung zweier Zenerdioden (Z1, Z2 bzw. Z3, Z4) und eines Widerstandes (R5 bzw. R6) geschaltet und der Mittelpunkt dieser jeweiligen Schaltung ist wiederum mit dem Knotenpunkt verbunden. Der Ausgang (OUT_ON) des ersten Komparators (COMP1) ist gleichzeitig der Ausgang des entsprechenden ON-Übertragungszweigs (82) und ist mit dem zugeordneten Eingang der Signalauswerteschaltung (84) verbunden.

Das Verhältnis der Kapazitäten der HV-Kondensatoren (C1, C3) zu denjenigen der zugeordneten weiteren Kondensatoren (C2, C4) der sekundärseitigen Beschaltung der jeweiligen Knotenpunkte (a2, b2) wird vorteilhaft derart gewählt, dass sich deren Kapazitäten verhalten wie C1/C2 = C3/C4 << 1. Die Durchbruchspannung der HV-Kondensatoren (C1, C3) ist erfindungsgemäß größer als die maximal auftretende Potentialdifferenz zwischen der sekundärseitigen Versorgungsspannung (vdd_hs) und dem primärseitigen Bezugspotential (gnd_pri). Solange im Rahmen des erfindungsgemäßen Übertragungsverfahrens keine Spannungstransienten an den sekundärseitigen Knotenpunkten (a2, b2) also zwischen primär- und sekundärseitigen Bezugspotentialen und Versorgungsspannungen auftreten befindet sich der Übertragungszweig im stationären Zustand. Die Potentiale an den sekundärseitigen Knotenpunkten (a2, b2), bezogen auf das sekundärseitige Bezugspotential (gnd_hs), werden dann durch die Spannungsteiler (R1, R2 bzw. R3, R4) und durch die Höhe der sekundärseitigen Versorgungsspannung (vdd_hs) bestimmt. Die Spannungsteiler sind derart ausgebildet, dass im stationären Gleichgewicht das Potential am ersten sekundärseitigen Knotenpunkt (a2) geringfügig höher, beispielhaft 100mV, als das Potential am zweiten sekundärseitigen Knotenpunkt (b2) ist. Damit wird gewährleistet, dass der erste Komparator (COMP1) im stationären Gleichgewicht derart angesteuert wird, dass sein Ausgang (OUT_ON) auf einem LOW- Zustand verharrt.

Weiterhin sind die Spannungsteiler (R1, R2 und R3, R4) derart gestaltet, dass die Potentiale an den sekundärseitigen Knotenpunkten (a2, b2) etwa der Hälfte der sekundärseitigen Versorgungsspannung (vdd_hs) entsprechen. Die weiteren Bauelemente (Z1, R5, Z2, bzw. Z3, Z4, R6) der Beschaltung der sekundärseitigen Knotenpunkte (a2, b2) begrenzen einen möglichen Verriss der Potentiale bei auftretenden Spannungstransienten an diesen Knotenpunkten (a2, b2) jeweils auf einen oberen und einen unteren Wert. Die Zenerspannung der Zenerdioden (Z1-Z4) ist dabei jeweils so gewählt, dass die Potentiale an den sekundärseitigen Knotenpunkten (a2 b2) nur Werte innerhalb eines bestimmten Spannungsfensters einnehmen können

Die erfindungsgemäße Signalübertragung durch Ladungsverschiebung an den HV-Kondensatoren (C1, C3) über einen Übertragungszweig erfolgt unabhängig davon ob das Bezugspotential (gnd_hs) der Sekundärseite statisch höher, gleich oder niedriger ist als das Bezugspotential (gnd_pri) der Primärseite.

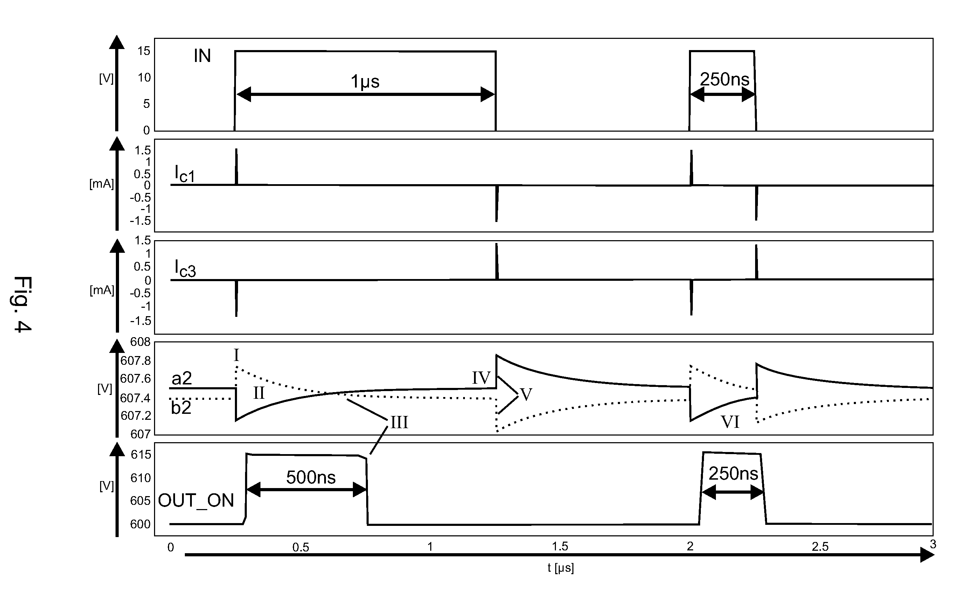

Nach dem erfindungsgemäßen Verfahren wird ein am Eingang (IN) des UP-Übertragers (82) anliegendes Eingangssignal direkt an den Eingang des ON-Übertragungszweigs (82) und invertiert auf den Eingang des OFF-Übertragungszweigs (83) angelegt. Aufgrund der identischen Ausführung des ON- und des OFF- Übertragungszweigs (82, 83) wird im Folgenden nur die Funktion des ON-Übertragungszweigs detailliert beschrieben. Erläuternd hierzu zeigt Fig. 4 zugehörige Simulationsergebnisse, bei einem positiven Bezugspotential der TOP-Sekundärseite (gnd_hs=600V). Das Bezugspotential der Primärseite (gnd_pri) liegt dabei beispielhaft auf Erdpotential (0V). Als Signalform wurden Rechtecksignale gewählt. Dargestellt sind jeweils das Signal am Eingang (IN), die Potentialverläufe an den Knotenpunkten (a2, b2) und das Signal am Ausgang (OUT_ON) des ON- Übertragungszweigs. Das Gesagte gilt für den OFF- Übertragungszweig in gleicher Weise mit vertauschter positiver und negativer Eingangssignalflanke.

Bei einer positiven Signalflanke am Eingang (IN) wird der erste n-Kanal Transistor (M1) eingeschaltet und der erste p-Kanal Transistor (M2) ausgeschaltet. Entsprechend sinkt das Potential am ersten primärseitigen Knotenpunkt (a1) transient von einer Spannung nahe der primärseitigen Versorgungsspannung (vdd_pri) zu einer Spannung nahe Erdpotential (gnd_pri) ab. Während dieser Spannungsänderung fließt ein Strom I_{C1}, entsprechend der allgemeinen Formel I_{C} = C *dU_{C}/dt über den ersten HV-Kondensator (C1) von der Sekundärseite zur Primärseite und zieht das Potential am sekundärseitigen Knotenpunkt (a2) gemäß der kapazitiven Spannungsteilerregel nach unten, beispielhaft um 300mV (Abschnitt I). Gleichzeitig wird durch den zweiten Inverter (INV2) eine negative Signalflanke an die zweite Brückenschaltung (M3, M4) angelegt, wodurch der zweite p-Kanal Transistor (M3) ausgeschaltet und der zweite p-Kanal Transistor (M4) eingeschaltet wird. Hierdurch steigt das Potential am zweiten primärseitigen Knotenpunkt b1 transient von einer Spannung nahe Erdpotential (gnd_pri) zu einer Spannung nahe primärseitgem Versorgungspotential (vdd_pri) an. Während der Spannungsänderung fließt ein Strom I_{C3} über den zweiten HV-Kondensator (C3) von der Primärseite zur Sekundärseite und zieht das Potential am sekundärseitigen Knotenpunkt (b2) nach oben, beispielhaft um 300mV (Abschnitt I). Durch diesen Potentialverriss mit entgegen gesetztem Vorzeichen, ist nun das Potential am sekundärseitigen Knotenpunkt (a2) geringer als am sekundärseitigen Knotenpunkt (b2), wodurch der Ausgang des UP- Übertragers (OUT_ON) den Wert HIGH annimmt. Nach dem Ende der Spannungstransienten nähern sich die Potentiale an den sekundärseitigen Knotenpunkten gemäß der ohmsch-kapazitiven Knotenimpedanz exponentiell mit der Zeitkonstante ihrem statischen Wert an (Abschnitt II). Die Zeitkonstante Tₐ₂ bzw. T_{b2} fasst alle ohmschen und kapazitiven Anteile, die an der Umladung der entsprechenden Knoten a2 bzw. b2 beteiligt sind, zusammen. Solange keine Ausschaltflanke am Eingang (IN) erscheint, schreitet die Entladung selbständig bis zum statischen Grundzustand fort (Abschnitt IV). Sobald der Entladevorgang soweit abgeklungen ist, dass der erste sekundärseitige Knotenpunkt (a2) auf einem höheren Potential als der zweite sekundärseitige Knotenpunkt (b2) liegt, beispielhaft nach 500ns, schaltet der Ausgang des Übertragungszweigs (OUT_ON) wieder auf LOW (Abschnitt III).

Die negative Flanke des Signals am Eingang (IN) bewirkt kein Ausgangssignal des ON- Übertragungszweigs (82) (Abschnitt V), vielmehr erzeugt diese ein nicht dargestelltes entsprechendes Signal am OFF- Übertragungszweig (83). Sollte das stationäre Gleichgewicht noch nicht erreicht sein, führt eine negative Signalflanke direkt zu einem LOW- Pegel am Ausgang (OUT_ON) des ersten Komparators (COMP1) (Abschnitt VI). Ebenso gilt, dass eine positive Flanke des Signals am Eingang (IN) immer zu einem HIGH-Pegel am Ausgang (OUT_ON) des ON-Übertragungszweiges (82) führt, unabhängig davon, ob sich bereits ein stationäres Gleichgewicht an den sekundärseitigen Knotenpunkten (a2, b2) eingestellt hat. Jede Flanke am Eingang (IN) führt somit immer zu einem korrelierenden Schaltzustand am Ausgang (OUT_ON), sofern dieser nicht bereits vorliegt. Es lassen sich somit auch Pulsfolgen hoher Frequenz übertragen.

Weitere Simulationen zeigen, dass die Signalübertragung durch Ladungsverschiebung an den HV-Kondensatoren unabhängig davon erfolgt, ob das Bezugspotential (gnd_hs) der Sekundärseite statisch höher, gleich oder niedriger als das Bezugspotential (gnd_pri) der Primärseite ist. Bei einem Schaltvorgang der Leistungsschalter, bei dem gleichzeitig oder kurz nacheinander der BOT- Schalter aus bzw. ein- und der TOP-Schalter ein- bzw. ausgeschaltet werden, steigt bzw. sinkt die Spannung am Ausgang der Halbbrücke mit einer schnellen Änderung pro Zeiteinheit (Spannungstransienten), von beispielhaft 10kV/µs. In gleichem Maße steigt gleichzeitig das Bezugspotential (gnd_hs) der Sekundärseite an. Während dieser Phasen ist eine Signalübertragung über die Übertragungszweige (82, 83) und damit über den gesamten UP-Übertrager (80) nicht möglich und auch nicht erwünscht.

Die Übertragung eines Signals von der Primär- auf die Sekundärseite über einen erfindungsgemäßen UP-Übertrager kann wie folgt zusammengefasst werden. Bei einer positiven Eingangssignalflanke wird am Ausgang (OUT_ON) des ON-Übertragungszweig (82) ein positiver Puls bestimmter Länge erzeugt, der von der Signalauswerteschaltung (84) erfasst wird. Daraufhin wird der Ausgang (OUT) des UP-Übertragers (80) auf einen Einschaltstatus, beispielhaft HIGH, gesetzt, der auch nach Ende des Signals am Ausgang (OUT_ON) ansteht. Der Ausgang (OUT_OFF) des OFF- Übertragungszweigs (83) verharrt auf LOW. Bei einer negativen Eingangssignalflanke wird am Ausgang (OUT_OFF) des OFF- Übertragungszweigs (83) ein positiver Puls bestimmter Länge erzeugt, der ebenfalls von der Signalauswerteschaltung (84) erfasst wird. Daraufhin wird der Ausgang (OUT) des UP-Übertragers (82) zurückgesetzt. Der Ausgang (OUT_ON) des ON-Übertragungszweigs (82) verharrt auf LOW. Das Signal am Eingang (IN) wird in vollständiger Länge übertragen und an die TOP-Sekundärseite (40) übergeben. Während hoher Spannungstransienten zwischen primärseitigem (gnd_pri) und sekundärseitigem Bezugspotential (gnd_hs) findet keine Signalübertragung statt. Die Ausgänge der Übertragungszweige (OUT_ON, OUT_OFF) verbleiben im LOW-Zustand bzw. werden auf den LOW- Zustand zurückgesetzt. Der gespeicherte Zustand am Ausgang (OUT) des UP-Übertragers (80) bleibt erhalten.

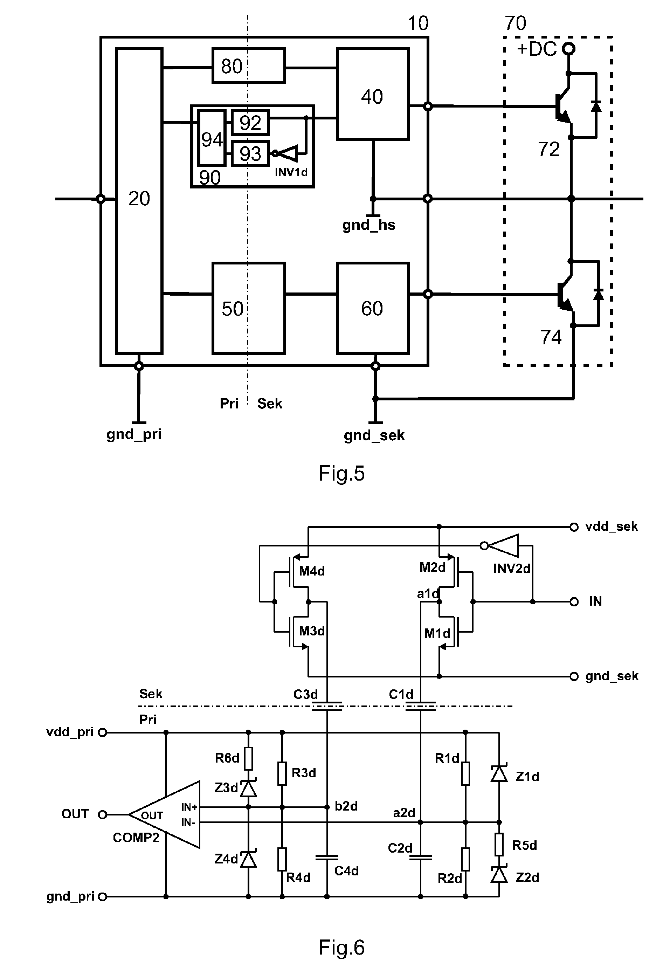

Fig. 5 zeigt ein Blockschaltbild mit relevanten Teilen einer zweiten erfindungsgemäßen monolithisch integrierten Ansteuerschaltung mit einem UP- und einem DOWN- Übertrager, wobei der DOWN- Übertrager komplementär zum UP-Übertrager aufgebaut ist. Der DOWN- Übertrager dient beispielhaft der Übertragung von Sensor- oder Statussignalen von der Sekundär- zur Primärseite.

Fig. 6 zeigt dazu eine Grundschaltung eines DOWN- Übertragers (90) als Teil einer erfindungsgemäßen monolithisch integrierten Ansteuerschaltung. Der DOWN-Übertrager (90) besteht analog zum UP-Übertrager (80) gemäß Fig. 3 aus einem ON-Übertragungszweig (92) und einem identischen OFF- Übertragungszweig (93), und einer diesen nach geschalteten Signalauswerteschaltung (94). Das auf der TOP-Sekundärseite (40) erzeugte zu übertragende Signal wird direkt an den ON-Übertragungszweig (92) und über einen dritten Inverter (INV3) an den OFF-Übertragungszweig (92) angelegt. Der Ausgang der Signalauswerteschaltung (94) ist an die Ansteuerlogik (20) der Primärseite (Pri) angeschlossen.

Zur primärseitigen Auswertung eines auf der TOP-Sekundärseite erzeugten Signals ist es meist nicht notwendig dieses Signal in vollständiger Länge zur Primärseite zu übertragen. Oftmals ist hier ein kurzer Übertragungspuls, beispielhaft bei der Erkennung eines Fehlers, zu dessen korrekter Auswertung ausreichend, weshalb es ausreichend sein kann, wenn der DOWN-Übertrager nur aus einem, dem ON- Übertragungszweig besteht.

## Patentansprüche

1. Ansteuerschaltung mit Übertragungsschaltung zur Übertragung eines Signals von einer Primärseite (Pri) mit erstem Grundpotential (gnd_pri) zu mindestens einer Sekundärseite (Sek) mit jeweiligem zweitem Grundpotential (gnd_hs) mit einem Übertrager (80) mit kapazitiver Kopplung zwischen der Primär- (Pri) und der Sekundärseite (Sek), wobei
der Übertrager (80) zwei Zweige, einen ON- Übertragungszweig (82) und einen OFF- Übertragungszweig (83) aufweist, die ihrerseits je einen ersten und einen zweiten Teilzweig aufweisen, wobei
die kapazitive Kopplung zwischen Primär- und Sekundärseite bei jedem Teilzweig durch Hochvolt-Kondensatoren (C1, C3) ausgeführt wird, die jeweils eine Reihenschaltung mit einem zugeordneten sekundärseitigen Kondensator (C2, C4) bilden, wobei
ein Signal (IN) am Eingang direkt an dem ON- Übertragungszweig (82) und über einen ersten Inverter (INV1) am OFF- Übertragungszweig (83) anliegt, und wobei innerhalb des jeweiligen Übertragungszweiges (82, 83) das Signal direkt an einem ersten und über einen zweiten Inverter an einem zweiten Teilzweig anliegt.

2. Ansteuerschaltung nach, Anspruch 1 wobei
jeder Teilzweig primärseitig eine Brückenschaltung (M1, M2 bzw. M3, M4) aus einem n-Kanal und einem p-Kanal Transistor aufweist, deren jeweiliger Mittelpunkt (a1, b1) mit einem zugeordneten HochVolt-Kondensator (C1, C3) verbunden ist, der wiederum sekundärseitig an einem jeweils zugeordneten Knotenpunkt (a2, b2) angeschlossen ist, der seinerseits mit den zugeordneten sekundärseitigen Kondensatoren (C2, C4) verbunden ist und eine zugeordnete Teilbeschaltung (820, 822) mit den zugeordneten Spannungsteilern (R1, R2 bzw. R3, R4) aufweist und wobei der zweite Anschluss der sekundärseitigen Kondensatoren (C2, C4) mit der sekundärseitigen Versorgungsspannung (vdd_hs) verbunden ist.

3. Ansteuerschaltung nach Anspruch 2, wobei
die sekundärseitigen Knotenpunkte (a2, b2) der jeweiligen Teilzweige mit einem Komparator (COMP1) verbunden sind.

4. Ansteuerschaltung nach Anspruch 2, wobei
das Potential an den sekundärseitigen Knotenpunkten (a2, b2) mittels geeigneter Ausgestaltung der zugeordneten Spannungsteiler (R1, R2 bzw. R3, R4) im stationären Zustand geringfügig unterschiedlich ist.

5. Ansteuerschaltung nach Anspruch 2, wobei
die Kapazitäten der weiteren Kondensatoren (C2, C4) wesentlich höher sind als diejenigen des zugeordneten ersten oder zweiten Kondensators (C1, C3).

6. Ansteuerschaltung nach Anspruch 2, wobei
die äußeren Anschlüsse der den Teilzweigen zugeordneten Spannungsteiler (R1, R2 bzw. R3, R4) mit dem sekundärseitigen Grundpotential (gnd_hs) bzw. der sekundärseitigen Versorgungsspannung (vdd_hs) verbunden sind.

7. Ansteuerschaltung nach Anspruch 3, wobei
die Ausgänge der beiden Komparatoren der Übertragungszweige (82, 83) mit einer Signalauswerteschaltung (84) verbunden sind.

8. Ansteuerschaltung nach einem der vorhergehenden Ansprüche, wobei
die Komponenten in einem Hochvolt-IC monolithisch integriert sind.

9. Verfahren zum Betrieb einer Ansteuerschaltung nach einem der vorhergehenden Ansprüche, wobei
ein primärseitiges Eingangssignal am Eingang (IN) des kapazitiven Übertragers (80) direkt an einen ON- Übertragungszweig (82) und invertiert an einen OFF-Übertragungszweig (83) angelegt wird, wobei
in jedem Übertragungszweig (82, 83) das dortige Signal einen Stromfluss durch einen ersten HV- Kondensator (C1) eines ersten Teilzweiges und einen inversen Stromfluss durch einen zweiten HV- Kondensator (C3) eines zweiten Teilzweiges erzeugt, dieser jeweilige Stromfluss auf der Sekundärseite (Sek) detektiert und einer beiden Teilzweigen gemeinsamen Auswerteschaltung (84) zugeführt wird, die das primärseitige Eingangssignal (IN) sekundärseitig rekonstruiert (OUT).

10. Verfahren zum Betrieb einer Ansteuerschaltung nach Anspruch 9, wobei die Detektion des sekundärseitigen Stromflusses eines Übertragungszweiges (82, 83) an zwei sekundärseitigen Knotenpunkten (a2, b2) der jeweiligen Teilzweige derart erfolgt, dass diese Knotenpunkte im stationären Grundzustand ein geringfügig unterschiedliches Potential aufweisen und die jeweils aktuellen Potentiale in einem zugeordneten Komparator (COMP1), dessen Ausgang den Ausgang (OUT) des Übertragungszweiges bildet, verglichen werden.
